# NEW EUROPEAN PATENT SPECIFICATION

(11) **EP 3 785 036 B2**
(45) Date of publication and mention of the opposition decision: **23.07.2025**
(45) Mention of the grant of the patent: 04.05.2022
(21) Application number: 19721052.9
(22) Date of filing: 21.03.2019
(51) Int. Cl.: G01R 27/02, A24F 40/80

(54) **A STATION FOR CHECKING THE ELECTRICAL CIRCUIT OF ELECTRONIC CIGARETTES**
STATION ZUR PRÜFUNG DER ELEKTRISCHEN SCHALTUNG VON ELEKTRONISCHEN ZIGARETTEN
POSTE DE CONTRÔLE DU CIRCUIT ÉLECTRIQUE DE CIGARETTES ÉLECTRONIQUES

(30) Priority: 24.04.2018 IT 201800004814
(43) Date of publication of application: 03.03.2021
(73) Proprietor: G.D S.p.A., 40133 Bologna (BO) (IT)
(72) Inventor: MORETTI, Carlo, 40132 Bologna (IT); TESTONI, Luca, 40013 Castel Maggiore (Bologna) (IT); CUCCHI, Manuele, 40069 Zola Predosa (Bologna) (IT); RENCO, Francesco, 40013 Castel Maggiore (Bologna) (IT); LANZARINI, Luca, 40053 Valsamoggia (Bologna) (IT); FEDERICI, Luca, Deceased (IT)
(74) Representative: Buzzi, Notaro & Antonielli d'Oulx S.p.A.
(86) International application number: PCT/IB2019/052299
(87) International publication number: WO 2019/207373

(56) References cited:
- WO-A1-2004/103792
- WO-A1-2015/007342
- WO-A1-2016/119171
- WO-A1-2016/127327
- WO-A1-2016/207136
- CN-U- 203 941 232
- US-A- 3 408 565
- US-A- 4 818 933
- US-A- 5 237 510
- US-A- 5 969 752
- US-A- 6 094 061
- US-A1- 2003 030 459
- US-A1- 2013 074 724
- US-B2- 6 563 301
- US-B2- 6 876 107
- US-B2- 9 586 760

## Description

The present invention falls within the technical sector of electronic cigarettes. In particular, the invention relates to a station for checking the electrical circuit of electronic cigarettes.

As known, in electronic cigarettes there is a cartridge through which a liquid is vaporized by supplying electrical energy to generate aerosols. The electrical circuit is present in the cartridge, which comprises a heating element that causes vaporization of the liquid, and terminals made of conductive material, which are connected to the heating element. The electronic cigarette also comprises a power supply battery which is connected to the terminals, allowing the heating element to be heated.

The correct functioning of the electrical circuit is essential to guarantee the quality of the finished product.

To date, electronic cigarettes are assembled in dedicated automatic machines, in which the various parts are fed into consecutive stations. The battery is usually coupled to the terminals at the end of the assembly. Therefore, it is necessary to check the electrical circuit before assembly is completed, to avoid waste of time and material.

Document WO2016/127327 discloses a device for measuring the resistance of e-cigarette atomizers arranged vertically on a support base.

Document CN203941232 describes a device for measuring the resistance of electronic cigarettes arranged vertically on seats of a transport wheel with a vertical axis.

Document WO2016/119171 describes a device for measuring the resistance of electronic cigarettes arranged horizontally on seats of a horizontal axis drum

The object of the present invention is to propose solutions that allow the electrical circuit of electronic cigarettes to be checked. This object is achieved by proposing a station for checking the electrical circuit of electronic cigarettes according to the attached claims.

Advantageously, the invention allows automatic checking of the electronic circuit of electronic cigarettes. Therefore, it is possible to guarantee the correct functioning (or rather, to guarantee the quality of the finished product, i.e. the electronic cigarettes).

This and other advantages will be made clear in the following discussion, with the aid of the attached drawings, in which:
- Figure 1 is a partial perspective view of a check station of the electrical circuit of electronic cigarettes in accordance with the present invention;
- Figure 2 is an enlarged view of the station of Figure 1;
- Figure 3 is a perspective view of a filling machine comprising a check station according to the present invention;
- Figure 4 is an enlarged view of the machine of Figure 3, according to a different perspective;
- Figure 5 is a view similar to that of Figure 2, with reference to a different embodiment not covered by the annexed claims.

With reference to the attached figures, numeral 1 indicates a check station of the electrical circuit of electronic cigarettes according to the present invention.

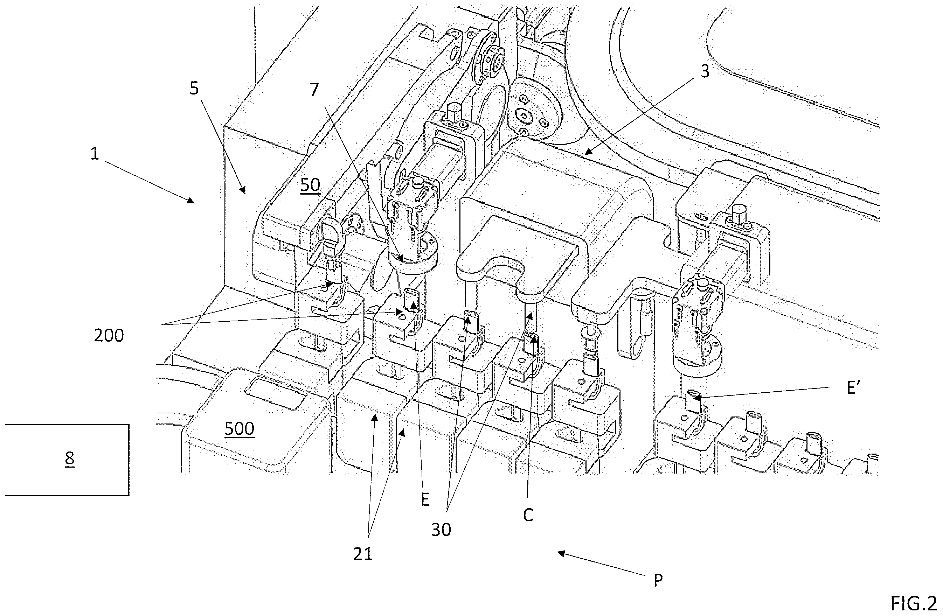

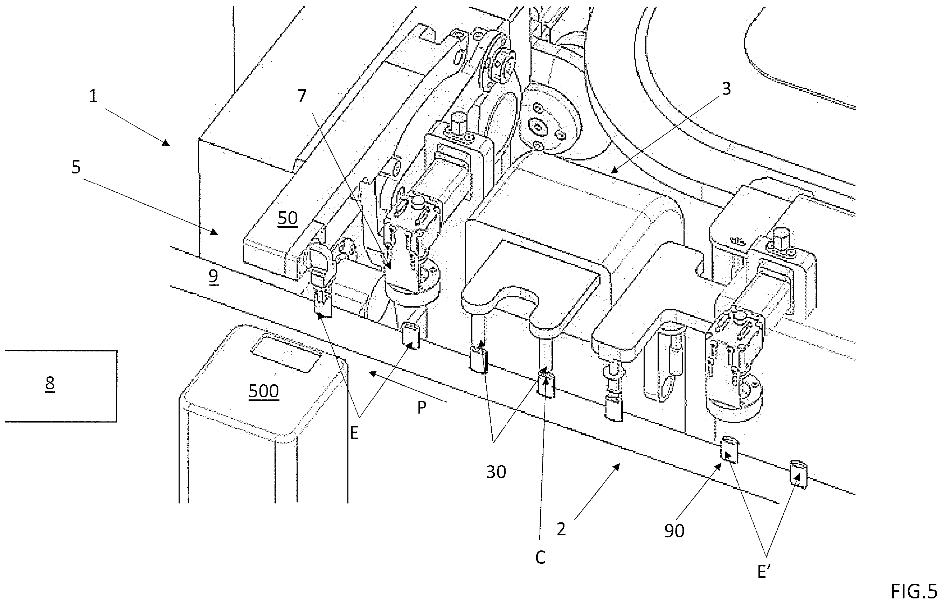

As already mentioned in the introductory part of the present discussion, the electrical circuit of an electronic cigarette (in particular of a cartridge of an electronic cigarette) comprises a heating element which causes vaporization of the liquid, along with terminals made of conductive material which are connected to the heating element. As known, in general, an electronic cigarette, once completely assembled also comprises a power supply battery which is connected to the terminals, allowing heating of the heating element. Since the battery is coupled to the terminals of the electrical circuit at the very end of the assembly, the check station described here allows the electrical circuit to be checked before it is coupled with the battery. With reference to the attached figures, the electrical circuit is indicated in Figures 2 and 5 with the reference C as a representative only, without being shown in detail.

For the sake of clarity, the term "electronic cigarettes" means, in this text, parts of electronic cigarettes (in particular the cartridges, as in the illustrated case) comprising at least the electrical circuit C.

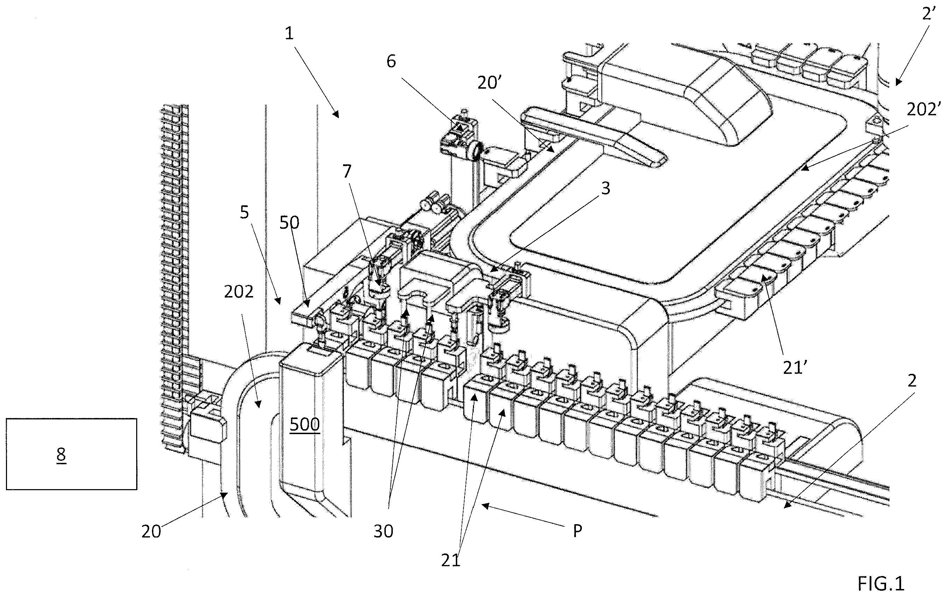

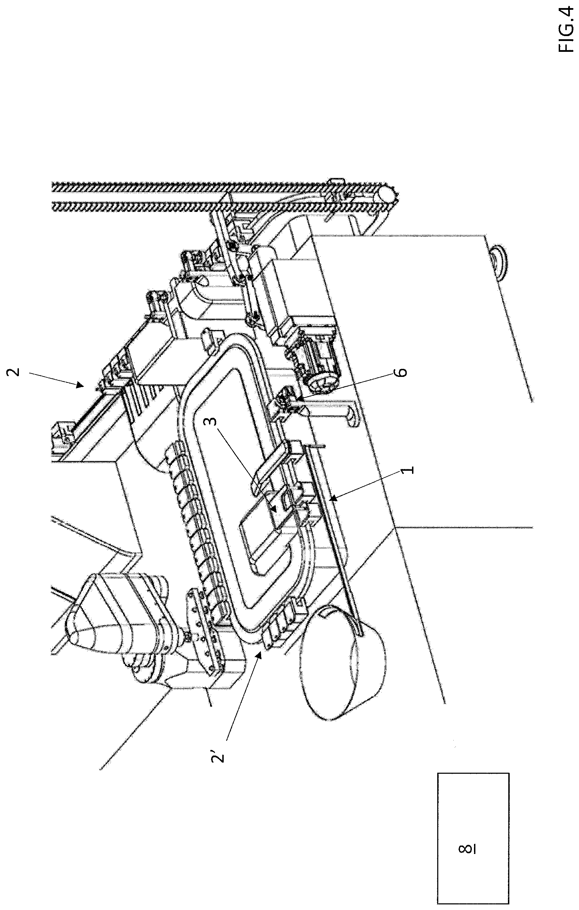

In accordance with a first embodiment of the invention, with reference to the attached Figures 1-4, the check station 1 comprises: at least one conveying device 2, 2' for conveying parts of electronic cigarettes E (in detail cartridges), each comprising an electrical circuit C along a advancement path P; and at least one control assembly 3 arranged along the advancement path P and comprising at least one head 30 provided with at least one electrical contact (preferably two, not visible in the attached figures). The head 30 can move towards the conveying device 2, 2' to contact, by means of the relative electrical contact, the electrical circuit C (the terminals) of the parts of electronic cigarettes E conveyed by the conveying device 2, 2'.

The check station 1 also comprises: a power supply assembly (not illustrated) which supplies the contacts of the control assembly 3 with electrical energy; and a measuring assembly 8 (illustrated only schematically in the figures) connected to the control unit 3, which measures a quantity of electrical energy representative of the electric resistance and/or the inductance of the electrical circuit C.

In detail, the conveying device 2, 2' comprising a plurality of movable units 21, 21' each arranged in order to receive the parts of electronic cigarettes E; the movable units 21, 21' being movable along the advancement path P independently from each other.

Advantageously, the proposed solution allows extreme precision of the checking operations. In fact, the movable units 21, 21' can position themselves accurately along the advancement path P, thus allowing optimum control.

The movable units 21, 21' comprise means for housing the parts of electronic cigarettes E, for example, the seats 200 (see Figure 2) or gripping means (e.g. clamps), or support members provided with suitable housings. These means are necessary because the parts of electronic cigarettes E, in particular - cartridges comprising the electrical circuit C - are parts with a particularly unstable arrangement.

With reference to the attached figures, the parts of electronic cigarettes E have a predominantly longitudinal development and are maintained in a vertical position during the relative transport.

The measured quantity of electrical energy can be a voltage (at a predetermined current), or a current (at a predetermined voltage), or a combination of voltage and current (when neither are predetermined), or a frequency of a voltage and/or a current (in the case of alternating current), or a phase shift between voltage and current (in the case of alternating current), or a time constant of voltage or current (in the case of direct current). In this way, when the electrical quantity is measured, the electrical resistance/inductance (or a representative value of these parameters) of the circuit (in particular of the heating element) can be determined thanks to the measuring assembly 8 which is able to convert it to that effect.

With reference to the attached Figures 1-4, the head 30 of the control assembly 3 moves along substantially vertical forward and return strokes and, in particular, perpendicular to the movable units 21, 21' which carry the parts of electronic cigarettes E to be checked (i.e. along a direction lying on a plane perpendicular to that on which the advancement path P lies).

According to an embodiment of the invention, illustrated in Figures 1-4, the conveying device 2, 2' further comprises: a guide 20, 20' arranged along the advancement path P and on which the movable units 21 can slide, 21'; a linear electric motor 202, 202' bound to the guide 20, 20' and comprising a plurality of coils (individually energizable); and a plurality of magnets (not shown) bound to the movable units 21, 21' for interacting with the coils of the linear electric motor 202, 202', allowing movement of the movable units 21, 21' along the guide 20, 20'. In other words, according to this embodiment, the conveying device 2, 2' is a linear motor conveyor. The electromagnetic field generated by the coils of the linear electric motor 202, 202' interacts with the magnets attached to the movable units 21, 21' to control their movement along the guide 20, 20'.

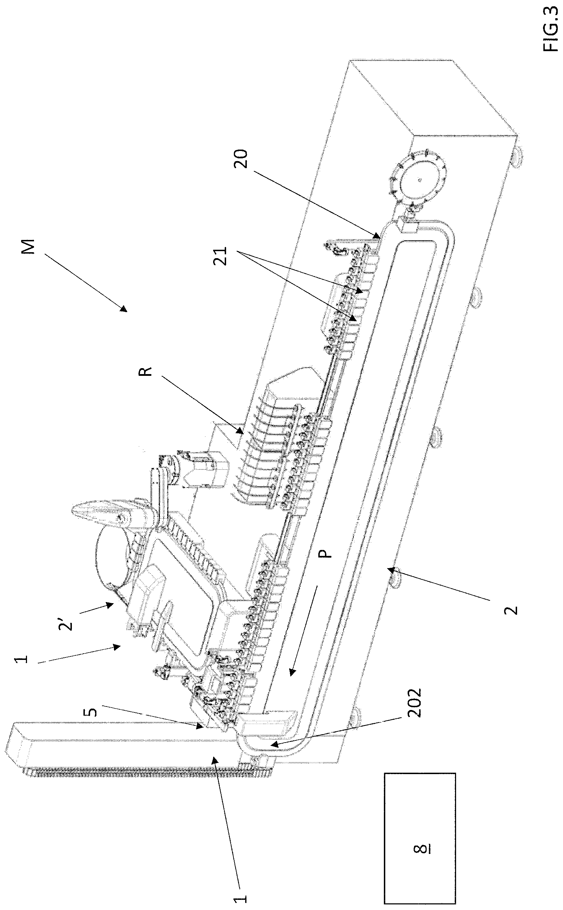

The guide 20, 20', again with reference to Figures 1-4, forms a closed-loop profile (see in particular Figure 3).

The movable units 21, 21' are preferably carriages, or rather, are provided with wheels (not shown in the attached figures) for sliding along the guide 20, 20'. Advantageously, the check station 1 in accordance with this embodiment is particularly efficient thanks to the movement of the carriages 21, 21' by means of the linear motor system.

With particular reference to Figures 1, 3 and 4, there are two conveying devices 2, 2', in particular two linear electric motor conveyors (formed by respective guides 20, 20', electric motors 202, 202', movable units 21, 21' and permanent magnets).

In general, the movable units 21, 21' (in particular the carriages) can also be moved in groups of two or more, depending on the configuration of the station 1. For example, there may be two heads 30 (as in the attached figures) in the control assembly 3, and two electrical circuits C can be checked simultaneously.

Preferably, the movable units 21, 21' are carried along the advancement path P, up to the control assembly 3, where they are stopped. In this case, the head 30 (or heads) of the control assembly 3 are only movable along vertical forward and return strokes, as previously described. Advantageously, this embodiment allows maximum precision, since checking the electrical circuit C occurs when it is stationary (i.e. with the movable units 21, 21' still).

According to an alternative, the movable units 21, 21' are carried along the advancement path P, up to the control assembly 3, where they continue to move (or rather, they are not stopped, but can, for example, be slowed down). In this case, the head 30 (or heads) of the control assembly 3 are movable, as well as along vertical forward and return strokes, also along horizontal forward and return strokes, or rather, they move to follow the movable units 21, 21' for a portion of their advancement path P. Advantageously, this embodiment allows maximum productivity, or rather, faster times, since checking of the electrical circuit C occurs when the latter is moving (or rather, when the movable units 21, 21' are moving).

Preferably the measuring assembly 8 comprises a central control unit 8 (illustrated only in a schematic manner in the figures), configured to compare the measured quantity of electrical energy with at least one reference value, and to generate a reject signal if the measured quantity of electrical energy is different from the at least one reference value. The reference value can clearly be a range of values.

According to the embodiment represented with particular reference to Figures 1 and 2, the check station 1 further comprises a reject assembly 5, arranged downstream of the control assembly 3 along the advancement path P, arranged for removing the parts of electronic cigarettes E for which a reject signal has been generated, from the advancement path P.

For example, the reject assembly 5 comprises a gripping device 50 (for example, a pick-and-place device) which, in the event that a reject signal has been generated for a given part of an electronic cigarette E, it takes the electronic cigarette E part from the movable unit 21, 21' and transfers it outside the advancement path P. For example, again with reference to Figures 1-4, the gripping device 50 transfers the parts of electronic cigarettes E to be discarded into a collection container 500 (part of the reject assembly 5) outside the advancement path P.

Advantageously, in this way, the parts of electronic cigarettes E that do not meet certain functional requirements are simply and quickly removed from the advancement path P.

The control assembly 3 may further comprise at least one first optical device 6 (see in particular Figures 1 and 3), arranged upstream of the control assembly 3 along the advancement path P for detecting an image of the electrical circuit C of the parts of electronic cigarettes E to be checked. The first optical device 6 is, for example, a camera.

In the solution shown in Figures 1-4, the conveying device 2, as already mentioned, comprises two linear electric motor conveyors. The advancement path P coincides partly with the first linear electric motor conveyor and partly with the second.

In particular, the first optical device 6 can detect any defects already present before the checking operation, or rather, any defects present on the parts that are fed upstream.

The control assembly 3 may further comprise at least one second optical device 7, arranged downstream of the control assembly 3 along the advancement path P, for detecting an image of the electrical circuit C of the checked parts of electronic cigarettes E. The second optical device 7 is, for example, a camera. The second optical device 7 can be provided instead of or in addition to the first optical device 6.

In particular, if the second optical device 7 is provided in addition to the first optical device 6 (as in the case illustrated), the second optical device 7 can detect any defects present both before and after the checking operation. In this way, by comparing the detected images, it is possible to establish whether the defects were caused during the checking operation itself.

In this way, with the first and/or second optical device 7, it is also possible to visually check the state of the electrical circuit C, in particular of the terminals (contacts), to possibly allow an association between detected malfunction and image (e.g. a detected geometric defect).

In particular, with reference to Figures 1-4, at the first conveying device 2' the electrical circuits C are fed and checked, while at the second conveying device 2' the circuits C are joined to a part of a cartridge and rechecked by another control assembly 3. With particular reference to Figures 2 and 5, the parts (or rather, cartridges) of electronic cigarettes comprising the electrical circuit C have been indicated with the reference E, while the reference E' indicates the parts (or rather, the cartridges) of electronic cigarettes that have not yet been provided with the relative electrical circuit C.

The present disclosure further relates to a method for checking the electrical circuit C of electronic cigarettes E (refer to Figures 1-4), which is not encompassed by the wording of the claims. This method can be implemented, for example, with the check station 1 described above.

The method includes the steps of:
- conveying parts of electronic cigarettes E comprising electrical circuits C along an advancement path P in independent movable groups, towards a control assembly 3 comprising a head 30 with at least one electrical contact.
- contacting - by means of at least one electrical contact - the electrical circuit C of the electronic cigarettes (E) conveyed along the advancement path P (moving the head 30 of the control assembly 3); and
- measuring a quantity of electrical energy representative of the electric resistance and/or inductance of the checked electrical circuit C.

Advantageously, the method described above allows the electrical circuits C to be checked in a particularly precise and effective manner, since the electrical circuits are moved independently from each other.

Preferably, the step of measuring a quantity of electrical energy representative of the electric resistance and/or inductance of the checked electrical circuit C comprises the sub-steps of:
- comparing the measured quantity of electrical energy with at least one reference value (or a range of values); and
- emitting a reject signal if the measured quantity of electrical energy is different from the at least one reference value.

In this way, it is possible to identify any malfunctions and discard non-compliant products.

Regarding the measurement of the quantity of electrical energy representative of the electrical resistance and/or of the inductance of the checked electrical circuit C, reference should be made to what has been said for the check station 1 described above.

According to a second embodiment not covered by the annexed claims, illustrated in Figure 5 is a check station 1 comprising: at least one conveying device 2, for conveying parts of electronic cigarettes E comprising electrical circuits C along an advancement path P; and a control assembly 3 arranged along the advancement path P comprising at least one head 30 provided with at least one electrical contact which is movable towards the conveying device 2, to contact (by means of the relative electrical contact) the electrical circuit C (the terminals) of the electronic cigarettes E conveyed by the conveying device 2.

The check station 1 further comprises: a power supply assembly (not illustrated) which supplies the contacts of the control assembly 3 with electrical energy; and a measuring assembly 8 connected to the control unit 3, which measures a quantity of electrical energy representative of the electric resistance and/or the inductance of the electrical circuit C.

The conveying device 2 comprising a belt 9 comprising means for housing the parts of electronic cigarettes E (comprising the electrical circuit C) and moving them along the advancement path P.

The belt 9 generally means any flat conveyor (for example, a tape), for example, a closed-loop belt (shown only partially in Figure 5).

This second embodiment represents an alternative to the first embodiment described above, aimed at solving the same technical problem.

The means for housing the parts of electronic cigarettes E are, for example, seats 90 (as in the illustrated case) or gripping means (e.g. clamps) or support members provided with suitable housings. These means are necessary because the parts of electronic cigarettes E, for example - cartridges comprising the electrical circuit C - are parts with a particularly unstable arrangement.

In particular, the parts (cartridges) of electronic cigarettes E are maintained with vertical alignment during the relative transport.

Possibly, guiding side walls (not shown in the illustrated embodiment) may be provided for stabilizing the parts of electronic cigarettes E during transport.

As already said for the previous embodiment, the measured quantity of electrical energy can be a voltage (at a predetermined current), or a current (at a predetermined voltage), or a combination of voltage and current (when neither are predetermined), or a frequency of a voltage and/or a current (in the case of alternating current), or a phase shift between voltage and current (in the case of alternating current), or a time constant of voltage or current (in the case of direct current). In this way, when the electrical quantity is measured, the electrical resistance/inductance (or a representative value of these parameters) of the circuit (in particular of the heating element) can be determined thanks to the measuring assembly 8 which is able to convert it to that effect.

With reference to the attached Figure 5, the head 30 of the control assembly 3 moves along substantially vertical forward and return strokes. In other words, the head 30 of the control assembly 3 moves perpendicularly to the conveying device 2, or rather, to the parts of electronic cigarettes E conveyed along the advancement path P.

Preferably, the belt 9 is moved to carry the parts up to the control assembly 3; then the belt 9 is stopped and, therefore, the parts are stationary at the control assembly 3 (in other words, the belt 9 is moved stepwise, or rather, with an alternating movement). In this case, the head 30 (or heads) of the control unit 3 are only movable along vertical forward and return strokes, as previously anticipated. Advantageously, this embodiment allows maximum precision, since checking of the electrical circuit C occurs when it is stationary.

According to an alternative, the belt 9 is moved to carry the parts along the advancement path P, up to the control assembly 3, where they continue to be moved (the belt 9 is not stopped, but moves continuously). In this case, the head 30 (or heads) of the control assembly 3 are movable, as well as along vertical forward and return strokes, also along horizontal forward and return strokes, or rather, they move to follow the parts carried by the belt 9 for a portion of their advancement path P. Advantageously, this embodiment allows maximum productivity, or rather, faster times, since checking of the electrical circuit C occurs when the latter is moving (or rather, when the belt 9 is moving).

Preferably, the measuring assembly 8 comprises a central control unit 8 (illustrated only schematically) configured to compare the measured quantity of electrical energy with at least one reference value, and to generate a reject signal if the measured quantity of electrical energy is different from the at least one reference value. The reference value can clearly be a range of values.

According to the embodiment represented in Figure 5, the check station 1 further comprises a reject assembly 5, arranged downstream of the control assembly 3 along the advancement path P, arranged for removing the parts of electronic cigarettes E for which a reject signal has been generated, from the advancement path P.

For example, the reject assembly 5 comprises a gripping device 50 (for example, a pick-and-place device) which, in the event that a reject signal has been generated for a given part of an electronic cigarette E, it takes the electronic cigarette part from the belt 9 and transfers it outside the advancement path P. For example, again with reference to Figures 5, the gripping device 50 transfers the parts of electronic cigarettes E to be discarded into a collection container 500 outside the advancement path P.

Advantageously, in this way, the parts of electronic cigarettes E that do not meet certain functional requirements are simply and quickly removed from the advancement path P.

The control assembly 3 may further comprise at least one first optical device 6 (not visible in Figure 5) arranged upstream of the control assembly 3 along the advancement path P for detecting an image of the electrical circuit C of the parts of electronic cigarettes E to be checked. The first optical device 6 is, for example a camera.

In particular, the first optical device can detect any defects already present before the checking operation, or rather, any defects present on the parts of electronic cigarettes E that are fed upstream (i.e. as supplied or assembled).

The control assembly 3 may further comprise at least one second optical device 7 arranged downstream of the control assembly 3 for detecting an image of the electrical circuit C of the checked parts of electronic cigarettes E. The second optical device 7 is, for example, a camera 7. The second optical device 7 can be provided instead of or in addition to the first optical device.

In particular, if the second optical device 7 is provided in addition to the first optical device, the second optical device 7 can detect any defects present both before and after the checking operation. In this way, by comparing the detected images, it is possible to establish whether the defects were caused during the checking operation itself.

In this way, with the first and/or second optical device 7, it is also possible to visually check the state of the electrical circuit C, in particular of the terminals (contacts), to possibly allow an association between detected malfunction and image (e.g. a detected geometric defect).

The present disclosure further relates to a method for checking the electrical circuit C of electronic cigarettes E (refer to Figure 5), which is not encompassed by the wording of the claims. This method can be implemented, for example, with the check station 1 described above.

The method includes the steps of:
- conveying parts of electronic cigarettes E comprising electrical circuits along an advancement path (P), by means of a belt (9), towards a control assembly (3);
- contacting - by means of at least one electrical contact - the electrical circuit C of the electronic cigarettes (E) conveyed along the advancement path P (moving the head 30 of the control assembly 3); and
- measuring a quantity of electrical energy representative of the electric resistance and/or inductance of the checked electrical circuit C.

Advantageously, the method described above allows the electrical circuits to be checked in a particularly stable and effective manner, and is constructively simple.

Preferably, the step of measuring a quantity of electrical energy representative of the electric resistance and/or inductance of the checked electrical circuit C comprises the sub-steps of:
- comparing the measured quantity of electrical energy with at least one reference value (or a range of values); and
- generating a reject signal if the measured quantity of electrical energy is different from the at least one reference value.

In this way it is possible to identify any malfunctions and discard non-compliant products.

Regarding the measurement of the quantity of electrical energy representative of the electrical resistance and/or of the inductance of the checked electrical circuit C, reference should be made to what has been said for the check station 1 described above.

The present invention also relates to an assembling machine (not illustrated) for electronic cigarettes E comprising a plurality of assembling stations arranged along an assembling path, and at least one first check station 1 for checking the electrical circuit C of electronic cigarettes E, and which is arranged upstream and/or downstream of the assembling stations and/or interposed between the assembling stations. The check station 1 can be of the type according to the first embodiment described above.

The present invention further relates to a filling machine M of electronic cigarettes E (clearly visible in Figure 3) comprising at least one filling station R for filling electronic cigarettes E with a product to be vaporized; and at least one first check station 1 according to the first embodiment for checking the electrical circuit C of electronic cigarettes E arranged upstream and/or downstream of the filling station R. The filling station R comprises, for example, a plurality of nozzles which dispense the product inside the parts of electronic cigarettes E (or rather inside the relative cartridges).

The assembling machine and the filling machine M described above each integrate the checking function of the electrical circuit C of the electronic cigarettes E.

The assembling machine and the filling machine M can also be connected together to form a single system.

## Claims

1. A station (1) for checking the electrical circuit (C) of electronic cigarettes (E), comprising:
a conveying device (2, 2'), for conveying parts of electronic cigarettes (E) each comprising an electrical circuit (C) along an advancement path (P);
a control assembly (3) arranged along the advancement path (P), and comprising at least one head (30) having at least one electrical contact, and which is movable towards the conveying device (2, 2') to contact - by means of its electrical contact - the electrical circuit (C) of the electronic cigarettes (E) conveyed by the conveying device (2, 2');
a power supply assembly, which supplies the electrical contacts of the control assembly (3) with electrical energy;
a measuring assembly (8), connected to the control assembly (3), which measures a quantity of electrical energy representative of the electric resistance and/or inductance of the electrical circuit (C);
the conveying device (2, 2') comprises a plurality of movable units (21, 21') each arranged in order to receive the parts of electronic cigarettes (E); the movable units (21, 21') being movable along the advancement path (P) independently from each other
wherein the conveying device (2, 2') further comprises: a guide (20, 20') positioned along the advancement path (P) and on which the movable units (21, 21') can slide; a linear electrical motor (202, 202') bound to the guide (20, 20'), and comprising a plurality of coils; a plurality of magnets bound to the movable units (21, 21') for interacting with the coils of the electrical linear motor (202, 202'), allowing the movable units (21, 21') to move along the guide (20, 20').

2. The station (1) according to any of the preceding claims, wherein the measuring assembly (8) comprises a central control unit (8) configured to compare the measured quantity of electrical energy with at least one reference value and to generate a reject signal if the measured quantity of electrical energy is different from the at least one reference value.

3. The station (1) according to the preceding claim, further comprising a reject assembly (5), arranged downstream from the control assembly (3) along the advancement path (P), and arranged for removing the parts of electronic cigarettes (E) for which a reject signal has been generated, from the advancement path (P).

4. The station (1) according to any of the preceding claims, wherein the control assembly (3) further comprises at least one first optical device (6) arranged upstream of the control assembly (3) along the advancement path (P) for detecting an image of the electrical circuit (C) of the parts of electronic cigarettes (E) to be checked.

5. The station (1) according to anyone of the preceding claims, wherein the control assembly (3) further comprises at least one second optical device (7) arranged downstream of the control assembly (3) for detecting an image of the electrical circuit (C) of the checked parts of electronic cigarettes (E).

6. An assembling machine for electronic cigarettes (E) comprising a plurality of assembling stations arranged along an assembling path and at least one first station (1) for checking the electrical circuit (C) of electronic cigarettes (E) according to any of the preceding claims, and which is arranged upstream and/or downstream of the assembling stations and/or interposed between the assembling stations.

7. A filling machine (M) for electronic cigarettes (E) comprising at least one filling station (R) for filling electronic cigarettes (E) with a product to be vaporized; and at least one first station (1) for checking the electrical circuit (C) of electronic cigarettes (E) according to any of the preceding claims, arranged upstream and/or downstream of the filling station (R).

## Patentansprüche

1. Station (1) zum Prüfen der elektrischen Schaltung (C) elektronischer Zigaretten (E), die Folgendes umfasst:
eine Fördervorrichtung (2, 2') zum Fördern von Teilen elektronischer Zigaretten (E), die je eine elektrische Schaltung (C) umfassen, entlang einer Vorschubstrecke (P) ;
eine Steuerbaugruppe (3), die entlang der Vorschubstrecke (P) angeordnet ist und mindestens einen Kopf (30), der mindestens einen elektrischen Kontakt aufweist und zur Fördervorrichtung (2, 2') hin bewegbar ist, umfasst, um - mittels seines elektrischen Kontakts - die elektrische Schaltung (C) der durch die Fördervorrichtung (2, 2') geförderten elektronischen Zigaretten (E) zu kontaktieren;
eine Stromversorgungsbaugruppe, die die elektrischen Kontakte der Steuerbaugruppe (3) mit elektrischer Energie versorgt;
eine mit der Steuerbaugruppe (3) verbundene Messbaugruppe (8), die eine Größe der elektrischen Energie, die repräsentativ für den elektrischen Widerstand und/oder die Induktivität der elektrischen Schaltung (C) ist, misst;
wobei die Fördervorrichtung (2, 2') eine Vielzahl bewegbarer Einheiten (21, 21'), die je derart angeordnet sind, dass sie die Teile elektronischer Zigaretten (E) aufnehmen, umfasst; wobei die bewegbaren Einheiten (21, 21') entlang der Vorschubstrecke (P) unabhängig voneinander bewegbar sind,
wobei die Fördervorrichtung (2, 2') ferner Folgendes umfasst: eine Führung (20, 20'), die entlang der Vorschubstrecke (P) positioniert ist und auf der die bewegbaren Einheiten (21, 21') entlanggleiten können; einen Elektrolinearmotor (202, 202'), der an die Führung (20, 20') angefügt ist und eine Vielzahl von Spulen umfasst; eine Vielzahl von an die bewegbaren Einheiten (21, 21') angefügten Magneten zum Wechselwirken mit den Spulen des Elektrolinearmotors (202, 202'), wodurch ermöglicht wird, dass sich die bewegbaren Einheiten (21, 21') entlang der Führung (20, 20') bewegen.

2. Station (1) nach einem der vorhergehenden Ansprüche, wobei die Messbaugruppe (8) eine zentrale Steuereinheit (8) umfasst, die konfiguriert ist, um den Wert der gemessenen Größe der elektrischen Energie mit mindestens einem Bezugswert zu vergleichen und ein Aussonderungssignal zu generieren, wenn der Wert der gemessenen Größe der elektrischen Energie von dem mindestens einen Bezugswert abweicht.

3. Station (1) nach dem vorhergehenden Anspruch, die ferner eine Aussonderungsbaugruppe (5) umfasst, die entlang der Vorschubstrecke (P) nach der Steuerbaugruppe (3) angeordnet ist sowie derart angeordnet ist, dass sie die Teile elektronischer Zigaretten (E), für die ein Aussonderungssignal generiert worden ist, von der Vorschubstrecke (P) entfernt.

4. Station (1) nach einem der vorhergehenden Ansprüche, wobei die Steuerbaugruppe (3) ferner mindestens eine entlang der Vorschubstrecke (P) vor der Steuerbaugruppe (3) angeordnete erste optische Vorrichtung (6) zum Detektieren eines Bilds der elektrischen Schaltung (C) der zu prüfenden Teile elektronischer Zigaretten (E) umfasst.

5. Station (1) nach einem der vorhergehenden Ansprüche, wobei die Steuerbaugruppe (3) ferner mindestens eine nach der Steuerbaugruppe (3) angeordnete zweite optische Vorrichtung (7) zum Detektieren eines Bilds der elektrischen Schaltung (C) der geprüften Teile elektronischer Zigaretten (E) umfasst.

6. Montagemaschine für elektronische Zigaretten (E), die eine Vielzahl von entlang einer Montagestrecke angeordneten Montagestationen und mindestens eine erste Station (1) zum Prüfen der elektrischen Schaltung (C) elektronischer Zigaretten (E) nach einem der vorhergehenden Ansprüche, die vor und/oder nach den Montagestationen angeordnet und/oder zwischen die Montagestationen gesetzt ist, umfasst.

7. Füllmaschine (M) für elektronische Zigaretten (E), die mindestens Folgendes umfasst: eine Füllstation (R) zum Befüllen elektronischer Zigaretten (E) mit einem zu verdampfenden Produkt; und mindestens eine erste Station (1) zum Prüfen der elektrischen Schaltung (C) elektronischer Zigaretten (E) nach einem der vorhergehenden Ansprüche, die vor und/oder nach der Füllstation (R) angeordnet ist.

## Revendications

1. Poste (1) de contrôle du circuit électrique (C) de cigarettes électroniques (E), comprenant :
un dispositif de transport (2, 2'), destiné à transporter des parties de cigarettes électroniques (E) comprenant chacune un circuit électrique (C) le long d'un trajet d'avancement (P) ;
un ensemble de commande (3) agencé le long du trajet d'avancement (P), et comprenant au moins une tête (30) ayant au moins un contact électrique, et qui est mobile vers le dispositif de transport (2, 2') pour venir en contact, au moyen de son contact électrique, avec le circuit électrique (C) des cigarettes électroniques (E) transportées par le dispositif de transport (2, 2') ;
un ensemble d'alimentation électrique, qui alimente les contacts électriques de l'ensemble de commande (3) en énergie électrique ;
un ensemble de mesure (8), raccordé à l'ensemble de commande (3), qui mesure une quantité d'énergie électrique représentative de la résistance électrique et/ou de l'inductance du circuit électrique (C) ;
le dispositif de transport (2, 2') comprend une pluralité d'unités mobiles (21, 21') chacune agencée pour recevoir les parties de cigarettes électroniques (E) ; les unités mobiles (21, 21') étant mobiles le long du trajet d'avancement (P) indépendamment les unes des autres,
dans lequel le dispositif de transport (2, 2') comprend en outre : un guide (20, 20') positionné le long du trajet d'avancement (P) et sur lequel les unités mobiles (21, 21') peuvent coulisser ; un moteur électrique linéaire (202, 202') lié au guide (20, 20'), et comprenant une pluralité de bobines ; une pluralité d'aimants liés aux unités mobiles (21, 21') pour interagir avec les bobines du moteur linéaire électrique (202, 202'), permettant aux unités mobiles (21, 21') de se déplacer le long du guide (20,20').

2. Poste (1) selon l'une quelconque des revendications précédentes, dans lequel l'ensemble de mesure (8) comprend une unité de commande centrale (8) configurée pour comparer la quantité d'énergie électrique mesurée avec au moins une valeur de référence et pour générer un signal de rejet si la quantité d'énergie électrique mesurée est différente de l'au moins une valeur de référence.

3. Poste (1) selon la revendication précédente, comprenant en outre un ensemble de rejet (5), agencé en aval de l'ensemble de commande (3) le long du trajet d'avancement (P), et agencé pour éliminer les parties de cigarettes électroniques (E) pour lesquelles un signal de rejet a été généré, du trajet d'avancement (P).

4. Poste (1) selon l'une quelconque des revendications précédentes, dans lequel l'ensemble de commande (3) comprend en outre au moins un premier dispositif optique (6) agencé en amont de l'ensemble de commande (3) le long du trajet d'avancement (P) pour détecter une image du circuit électrique (C) des parties de cigarettes électroniques (E) destinées à être contrôlées.

5. Poste (1) selon l'une quelconque des revendications précédentes, dans lequel l'ensemble de commande (3) comprend en outre au moins un second dispositif optique (7) agencé en aval de l'ensemble de commande (3) pour détecter une image du circuit électrique (C) des parties de cigarettes électroniques (E) contrôlées.

6. Machine d'assemblage de cigarettes électroniques (E) comprenant une pluralité de postes d'assemblage agencés le long d'un trajet d'assemblage et au moins un premier poste (1) de contrôle du circuit électrique (C) de cigarettes électroniques (E) selon l'une quelconque des revendications précédentes, et qui est agencé en amont et/ou en aval des postes d'assemblage et/ou intercalé entre les postes d'assemblage.

7. Machine de remplissage (M) de cigarettes électroniques (E) comprenant au moins un poste de remplissage (R) destiné à remplir des cigarettes électroniques (E) avec un produit destiné à être vaporisé ; et au moins un premier poste (1) destiné à contrôler le circuit électrique (C) de cigarettes électroniques (E) selon l'une quelconque des revendications précédentes, agencé en amont et/ou en aval du poste de remplissage (R).
